Europäisches Patentamt

European Patent Office

Office européen des brevets

(11) Veröffentlichungsnummer: **0 517 152 A2**

# EUROPÄISCHE PATENTANMELDUNG

(21) Anmeldenummer: **92109262.3**

(22) Anmeldetag: **02.06.92**

(51) Int. Cl.⁵: **H01R 23/68**

(30) Priorität: **06.06.91 DE 4118563**

(43) Veröffentlichungstag der Anmeldung:
**09.12.92 Patentblatt 92/50**

(84) Benannte Vertragsstaaten:
**DE ES FR IT**

(71) Anmelder: **ABB PATENT GmbH**
**Kallstadter Strasse 1**
**W-6800 Mannheim 31(DE)**

(72) Erfinder: **Rothmeier, Erich**
**Adersbacher Strasse 30**
**W-6920 Sinsheim-Rohrbach(DE)**
Erfinder: **Cwetanski, Georgi**
**Hans-Purrmann-Strasse 66**
**W-6710 Frankenthal(DE)**

(74) Vertreter: **Rupprecht, Klaus, Dipl.-Ing. et al**
**c/o ABB Patent GmbH, Postfach 10 03 51**
**W-6800 Mannheim 1(DE)**

(54) **Elektronische Schaltungsanordnung.**

(57) Eine elektronische Schaltungsanordnung mit elektrischleitend miteinander verbundenen elektronischen Bauteilen (14, 15...), z. B. Dioden und dgl., deren Anschlüsse als aus den Bauteilen herausragende Anschlußdrähte (141, 142, 151, 152...) ausgebildet sind, werden jeweils elektrisch-leitend mittels starrer Verbindungsstücke (24, 25; 26, 27) aus elektrisch leitendem Material miteinander verbunden. Dadurch bildet die Schaltungsanordnung eine räumlich starre Einheit, deren Steifigkeit durch die Steifigkeit der Bauelemente (14, 15...) der Anschlußdrähte (141, 142; 151, 152...) und der Verbindungsstücke (24, 25...) bestimmt ist.

An den Verbindungsstücken (24, 25; 26, 27) sind Laschen (30, 31; 28, 29) angeformt, an denen Anschlußleitungen angeschlossen werden können.

Fig. 2

EP 0 517 152 A2

Die Erfindung betrifft eine elektronische Schaltungsanordnung gemäß dem Oberbegriff des Anspruches 1.

Weiter betrifft die Erfindung ein Verfahren zur Herstellung der Schaltungsanordnung sowie ein Gitterbauteil, welches im Zuge des Verfahrens zur Herstellung der Schaltungsanordnung benutzt werden kann.

Schaltungsanordnungen der eingangs genannten Art werden normalerweise auf Leiterplatten aufgebracht, die zu diesem Zweck Locher besitzen und an diese anschließenden Leiterbahnen, die durch Wegätzen der nicht benötigten Bereiche der Kupferkaschierung der Leiterplatte erzeugt werden.

Insbesondere bei Schützen sind Beschaltungen vorzusehen, die aus elektronischen Bauelementen bestehen, die nicht immer auf einer Leiterplatte aufgebracht und an das Schütz angebaut werden können. Aus diesem Grunde muß man die elektronischen Bauteile in besonders spezieller Weise anordnen, z. B. bei Schützspulen in bestimmten Taschen oder Aufnahmeräumen des Spulenkörpers. Diese konstruktive Lösung ist sehr aufwendig.

Aufgabe der Erfindung ist es, eine Schaltungsanordnung als vorfertigbare Einheit auszubilden sowie ein Verfahren anzugeben, wie diese Einheit erzeugt werden kann.

Die elektronische Schaltungsanordnung ist gekennzeichnet durch die Merkmale des Anspruches 1.

Die Bauteile mit ihren Anschlußdrähten und den Verbindungsstücken bilden somit eine steife Einheit, wobei an bestimmten Punkten dieser steifen Einheit die Anschlußleitungen angebracht werden können, beispielsweise durch Crimp-, Löt- etc. -verbindungen. Die Anschlußdrähte der Bauelemente können an die Verbindungsstücke angelötet oder an den Verbindungsstücken gemäß den kennzeichnenden Merkmalen des Anspruches 3 festgeklemmt sein; die Verbindungsstücke können Zapfen aufweisen, an denen die Anschlußleitungen anschließbar sind. An den freien Enden der Zapfen können Anschlußklemmen befestigt sein, siehe Anspruch 5, an denen die Anschlußleitungen festgeklemmt werden.

Wenn die elektronische Schaltungsanordnung als Gleichrichter-Brückenschaltung ausgebildet ist, dann sind die elektronischen Bauelemente als Dioden ausgebildet, die in der Form eines Recht- oder Viereckes räumlich einander zugeordnet sind; die Verbindungsstücke befinden sich an den Eckpunkten des Recht- oder Viereckes.

Die mit Wechselstrom verbundenen Verbindungsstücke, die sich diametral gegenüberstehen, besitzen in bevorzugter Ausführung an ihren aufeinanderzuweisenden Kantenbereichen je einen Vorsprung, an deren freien Enden je ein Anschlußdraht eines weiteren Bauelementes, vorzugsweise eines Varistorbauelementes befestigt sind.

In bevorzugter Weise bilden die Verbindungsstücke mit den Vorsprüngen eine L-Form, deren einer Schenkel die Vorsprünge enthält und deren anderer Schenkel die freien Anschlußklemmen trägt.

Wie oben erwähnt, bildet diese erfindungsgemäße Schaltungsanordnung eine räumlich relativ starre bzw. steife Form, so daß eine derartige Schaltungsanordnung fabrikfertig hergestellt und vorproduziert werden kann. Ggf. kann sie auch noch in Gießharz eingegossen werden, so daß eine weitere Versteifung der Schaltungsanordnung bewirkt wird.

Das Verfahren zur Herstellung einer derartigen erfindungsgemäßen Schaltungsanordnung geschieht auf folgende Weise: Zunächst wird ein Gitterbauteil hergestellt, bei dem die einzelnen Verbindungsstücke, die später zur Aufnahme der Anschlußdrähte der Bauelemente bzw. zum Anschließen derselben dienen, mittels Stegen verbunden sind. Danach werden die Bauteile dadurch an den Verbindungsstücken angebracht, daß die Anschlußdrähte daran angeschlossen werden, was durch Anlöten, Anklemmen oder auf sonstige Weise erfolgen kann; danach werden die Verbindungsstücke freigestanzt, in dem die Stege entfernt werden.

Eine weitere Möglichkeit besteht darin, daß ein Gitterbauteil aus Blech gestanzt wird, bei dem die Verbindungsstücke untereinander mittels der Stege verbunden sind und an das den Verbindungsstücken oder den Stegen anschließende weitere Stege aufweist; danach werden die Bauteile an den weiteren Stegen mechanisch befestigt, und zwar lediglich zu Halterungszwecken, wonach die Anschlußdrähte mit den Verbindungsstücken elektrisch-galvanisch verbunden werden. Schlußendlich werden die Verbindungsstücke durch Entfernen der Stege und der weiteren Stege freigestanzt.

Insbesondere bei der letzten Ausführung können die Bauelemente unmittelbar an dem Gitterbauteil gehaltert werden, ohne daß zusätzliche Haltevorrichtungen erforderlich werden.

Während des Stanzverfahrens entsteht ein Gitterbauteil, das gemäß den kennzeichnenden Merkmalen des Anspruches 11 ein Recht- oder Vieleck darstellt, wobei die weiteren Stege innerhalb des Rechteckes angeordnet sind.

Weitere vorteilhafte Ausgestaltungen des Gitterbauteils sind den weiteren Unteransprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen:

Figur 1

eine normale Gleichrichter-Brückenschaltungsanordnung,

Figur 2

eine erfindungsgemäß ausgebildete Schaltungsanordnung,

Figur 3

ein Gitterbauteil vor Montage,

Figur 4

ein Gitterbauteil zur Demonstration der wegzustanzenden Teile,

Figur 5a bis 5c

drei unterschiedliche Ausgestaltungen zur Halterung der elektronischen Bauelemente,

Figur 6a bis 6c

drei Befestigungsarten für die Anschlußdrähte an den elektronischen Bauelementen und

Figur 7

die Anbringung einer Anschlußklemme.

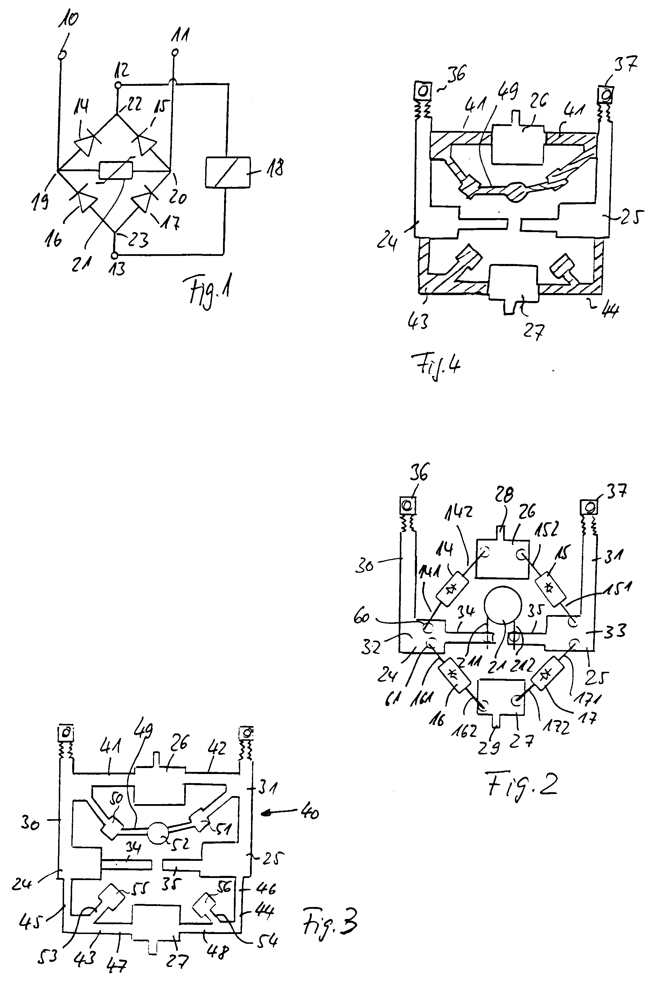

Die Schaltungsanordnung gemäß Figur 1 besitzt Anschlußklemmen 10 und 11 für Wechselstrom sowie Anschlußklemmen 12 und 13 für Gleichstrom. Dazwischen befinden sich in üblicher Weise Dioden 14, 15, 16 und 17; an den Gleichstromanschlüssen 12 und 13 ist ein Relais 18 angeschlossen, mit dem ein Schalter betätigt werden kann. Zwischen den Wechselstrom-Eckpunkten 19 und 20 ist ein Varistor 21 eingeschaltet. Die Gleichstromanschlüsse 12 und 13 Gleichstromek-ken 22 und 23 verbunden.

Die Anordnung nach Figur 2 zeigt die räumlich konstruktive Ausgestaltung der Schaltungsanordnung. Man erkennt die Dioden 14, 15, 16 und 17, deren Anschlußdrähte 141, 142 bzw. 151, 152 an Verbindungsstücken 24, 25, 26 und 27 wie folgt angeschlossen sind:

Die Anschlußdrähte 141 sind an dem Verbindungsstück 24, die Anschlußdrähte 142, 152 an dem Verbindungsstück 26 usw. angeschlossen. Die beiden Verbindungsstücke 26 und 27 besitzen eine rechteckige Form, wobei an den entgegengesetzt liegenden Kanten Anschlußzapfen 28 und 29 angebracht sind, die die Eckpunkte bzw. Anschlußpunkte 12 und 13 bilden. Die beiden sich ebenfalls gegenüberliegenden Verbindungsstücke 24 und 25 besitzen eine L-Form mit einem ersten Schenkel 30 bzw. 31 und einem zweiten Schenkel 32 bzw. 33, wobei der Schenkel 32 und 33 durch Anformung eines Vorsprunges 34 und 35 gestuft ist. Die beiden Vorsprünge 34 und 35 fluchten miteinander und weisen aufeinander zu. An den Endpunkten der beiden Vorsprünge 34 und 35 ist je ein Anschlußdraht 211 bzw. 212 des Varistors angeschlossen. Die beiden Schenkel 30 und 31 verlaufen einander parallel und an ihren freien Enden sind Anschlußklemmen 36 und 37 angebracht.

Zur Bildung der Schaltungsanordnung gemäß Figur 2 wird zunächst Gitterbauteil 40 hergestellt, bei dem die Verbindungsstücke 24 und 25 bzw. 26 und 27 mittels Stegen 41, 42 bzw. 43 und 44 zu einem Rechteck verbunden sind. Die beiden Stege 41 und 42 verlaufen senkrecht zu den Schenkeln 30 und 31 und parallel zu den Vorsprüngen 34 und 35, während die Schenkel 43 und 44 eine L-Form bilden, von denen der eine Schenkel 45 bzw. 46 an der Außenkante der Verbindungsstücke 24 und 25 in Richtung der Schenkel 30 und 31 verlaufen, wogegen die anderen Schenkel 47 und 48 aufeinander zu weisen, parallel zu den beiden Stegen 41 und 42 verlaufen und in das Verbindungsstück 27 einmünden.

Von den Verbindungsecken zwischen den Schenkeln 30 und 31 bzw. 41, 42 aus, verläuft ein Zug weiterer Stege 49 in einer Art Bogenform, wobei in dem Stegzug zwei rechteckige Erweiterungen 50, 51 sowie eine kreisförmige Erweiterung 52 zu sehen ist.

Unter einem Winkel zu den Schenkeln 47 und 48 sind weitere Stege 53 und 54 vorgesehen, an deren freien Enden Erweiterungen 55 und 56 vorgesehen sind.

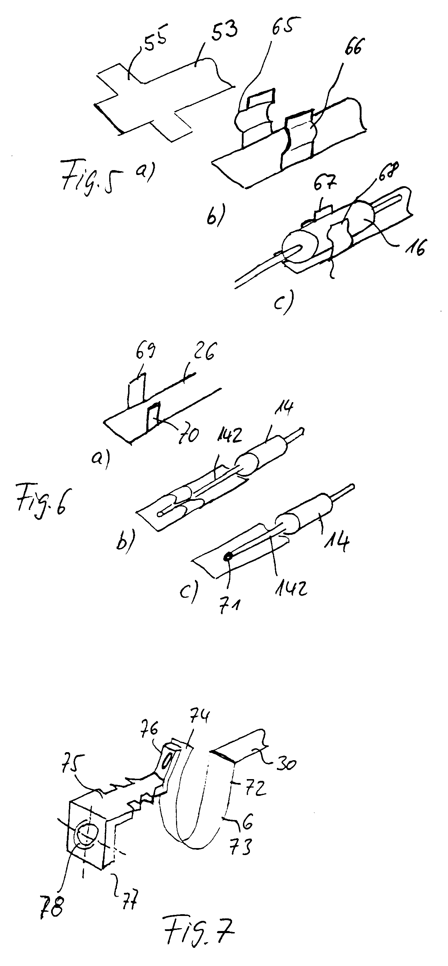

Dieses Gitterbauteil Figur 3, dient als Halterung bzw. als Montageteil zur Herstellung der Schaltungsanordnung gemäß Figur 2.

Die Erweiterungen 50, 51 und 52 sowie 55 und 56 sind so ausgebildet, daß sie die elektrischen Bauelemente, nämlich die Erweiterungen 50, 51; 55 und 56 die Dioden 14, 15 bzw. 16, 17 aufnehmen, siehe weiter unten, und haltern, wogegen der Varistor 21 an der Erweiterung 52 festgehalten ist. Danach werden die Anschlußdrähte 141, 142... an den entsprechenden Verbindungsstücken 24, 25; 26, 27 angebracht und angelötet, welche zu diesem Zweck jeweils Löcher 60, 61 aufweisen.

Die Figur 4 zeigt die Anordnung nach Figur 3, wobei diejenigen Teile, die weggestanzt werden, schraffiert sind. Es sind dies weiteren Stege 41 und 42, 49, 43 und 44. Die nicht schraffierten Teile, nämlich die Verbindungsstücke 24, 25 sowie 26 und 27 bleiben erhalten, und werden mittels der einzelnen Bauelemente 14 bis 17, 21 zu der Einheit gemäß Figur 2 zusammengesetzt und zusammengehalten. Die Einheit gemäß Figur 2 ist relativ steif, so daß sie eine in sich geschlossene, vorfertigbare Baueinheit darstellt.

Die Figur 5 zeigt drei unterschiedliche Ausführungsformen zur Halterung der elektrischen Bauelemente; die Ausgangsform ist beispielsweise die Erweiterung 55, welche auch, wie in Figur 5a gezeigt ist, durch eine Kreuzform gebildet werden kann. Die beidseitig über den Steg 53 hinausragenden Erweiterungsbereiche werden, wie in der Figur 5b gezeigt ist, mit einer Sicke 65 und 66 versehen, so daß in den Zwischenraum zwischen den beiden parallel zueinander verlaufenden Erweiterungsbereichen ein elektrisches oder elektronisches Bauelement eingesetzt werden kann.

Die Figur 5c zeigt dies deutlich: Zwischen den beiden Erweiterungsteilen, die hier die Bezugsziffern 67 und 68 erhalten, wird beispielsweise die Diode 16 eingeklemmt.

Die Figur 6 zeigt wie ein Verbindungsstück ausgebildet sein kann, damit die Anschlußdrähte 141 bzw. 142 daran befestigt werden können. Man erkennt beispielsweise das Verbindungsstück 26. An diesem Verbindungsstück sind senkrecht dazu hochstehende Laschen 69, 70 angeformt, die - wie aus Figur 6b ersichtlich ist - nach innen umgebogen werden und den Anschlußdraht 142 der Diode 14 festgeklemmt werden kann. Die Figur 6c zeigt eine Lötstelle 71 für den Anschlußdraht 142 des Bauelementes 14.

Die Figur 7 zeigt eine Detailansicht in perspektivischer Darstellung einer Anschlußklemme. Man erkennt beispielsweise den Schenkel 30, an den ein U-förmig gebogenes Verlängerungsstück 72 mit seinem einen Schenkel 73 anschließt; an der Außenseite des anderen Schenkels 74 ist eine Z-förmige Anschlußklemme 75, die beispielsweise der Anschlußklemme 36 entspricht, angeschlossen. Diese Anschlußklemme 75 besitzt einen ersten Schenkel 76, der an der Außenfläche des Schenkels 74 angelötet wird. Der andere Schenkel 77 enthält eine Gewindebohrung 78 zum Einschrauben einer Klemmschraube.

Die Ausführung nach der Figur 3 wird aus einem vier- oder rechteckigen Blech ausgestanzt; zur Herstellung der fertigen Schaltungsanordnung werden nach Montage der elektronischen Bauteile die nicht mehr benötigten Stege bzw. weiteren Stege weggestanzt, so daß dann, wenn keine Bauelemente vorhanden wären, vier miteinander nicht in Verbindung stehende Verbindungsstücke 24 bis 27 vorhanden sind. Die Verbindung der Verbindungsstücke erfolgt am fertigen Produkt, d. h. also an der Schaltungsanordnung nach Figur 2, durch die elektronischen Bauteile. Die Steifigkeit der Anordnung wird einerseits durch die Steifigkeit der Verbindungsstücke und andererseits durch die Steifigkeit der Anschlußdrähte 141, 142... der Bauteile 14... bewirkt.

**Patentansprüche**

1. Elektronische Schaltungsanordnung mit elektrisch-leitend miteinander verbundenen elektronischen Bauteilen, z. B. Dioden und dgl., deren Anschlüsse als aus den Bauteilen herausragende Anschlußdrähte ausgebildet sind, dadurch gekennzeichnet, daß die elektrischleitend zu verbindenden Anschlußdrähte (141, 142; 151, 152...) zweier oder mehrerer elektronischer Bauteile (14, 15...) mittels Verbindungsstücken (24, 25, 26, 27) aus elektrisch leitendem Material miteinander verbunden sind und daß die Schaltungsanordnung eine räumlich steife Einheit bildet, deren Steifigkeit durch die Steifigkeit der Bauelemente bzw. deren Anschlußdrähte und der Verbindungsstücke bestimmt ist.

2. Schaltungsanordnung nach Anspruch 1, dadurch gekennzeichnet, daß die Anschlußdrähte (141, 142) an den Verbindungsstücken (24, 25...) angelötet sind.

3. Schaltungsanordnung nach Anspruch 1, dadurch gekennzeichnet, daß an den Verbindungsstücken (24, 25...) Laschen (62, 63) angeformt sind, mit denen die Anschlußdrähte (141, 142...) festklemmbar sind.

4. Schaltungsanordnung nach einem der vorherigen Ansprüche, dadurch gekennzeichnet, daß die Verbindungsstücke (24, 25...) Zapfen (30, 31; 28, 29) aufweisen, an denen Anschlußleitungen anschließbar sind.

5. Schaltungsanordnung nach Anspruch 4, dadurch gekennzeichnet, daß an wenigstens zwei Zapfen Anschlußklemmen (36, 37) befestigt sind.

6. Als Gleichrichter-Brückenschaltung ausgebildete Schaltungsanordnung, mit als Dioden ausgebildeten elektronischen Bauelementen, nach einem der Ansprüche 1 bis 5, dadurch gekennzeichnet, daß die elektronischen Bauelemente (14, 15...) in Form eines Recht- oder Viereckes einander zugeordnet sind und daß die Verbindungsstücke (24, 25...) an den Eckpunkten des Recht- oder Viereckes angeordnet sind.

7. Schaltungsanordnung nach Anspruch 6, dadurch gekennzeichnet, daß die mit Wechselstrom zu verbindenden Verbindungsstücke (24, 25) die sich diametral gegenüberstehen, an ihren aufeinanderzuweisenden Kantenbereichen je einen Vorsprung (34, 35) aufweisen, an deren freien Enden je ein Anschlußdraht (211, 212) eines weiteren Bauelementes (21), vorzugsweise eines Varistorelementes, befestigt ist.

8. Schaltungsanordnung nach Anspruch 7, dadurch gekennzeichnet, daß die mit Wechselstrom verbundenen Verbindungsstücke mit den Vorsprüngen eine L-Form bilden, deren einer Schenkel die Vorsprünge (34, 35) enthält und deren andere Schenkel (30, 31) die die Anschlußklemmen (36, 37) tragenden Zapfen bilden.

9. Verfahren zur Herstellung einer Schaltungsanordnung nach einem der vorherigen Ansprüche, dadurch gekennzeichnet, daß die Verbindungsstücke (24, 25...) aus einem Blechteil wie folgt hergestellt werden:
 - Stanzen eines Gitterbauteiles, bei dem die Verbindungsstücke miteinander mittels Stegen verbunden sind,
 - Anbringen der Bauteile und Anschließen (z. B. Anlöten) der Anschlußdrähte der Bauteile an den Verbindungsstücken,
 - Freistanzen der Verbindungsstücke durch Entfernen der Stege.

10. Verfahren zur Herstellung einer Schaltungsanordnung nach einem der Ansprüche 1 bis 8, dadurch gekennzeichnet, daß die Verbindungsstücke aus einem Blechteil wie folgt hergestellt werden:
 - Stanzen eines Gitterbauteiles, bei dem die Verbindungsstücke untereinander mittels Stegen verbunden sind und das an den Verbindungsstücken oder Stegen anschließende weitere Stege aufweist,
 - mechanisches Befestigen der Bauteile an den weiteren Stegen und Anschließen der Anschlußdrähte (z. B. Anlöten) an den Verbindungsstücken,
 - Freistanzen der Verbindungsstücke durch Entfernen der Stege und der weiteren Stege.

11. Gitterbauteil zur Verwendung bei der Durchführung des Verfahrens nach einem der Ansprüche 9 und 10, dadurch gekennzeichnet, daß die Verbindungsstücke (24, 25...) mit den Stegen (41, 42; 43, 44) ein Rechteck bilden und daß die weiteren Stege (49, 53, 54) innerhalb des Rechteckes angeordnet sind.

12. Gitterbauteil nach Anspruch 11, dadurch gekennzeichnet, daß die weiteren Stege (49; 53, 54) einen geschlossenen Stegzug bilden oder frei enden und mit Erweiterungen (50, 51, 52; 55, 56) versehen sind, auf denen die Bauteile (14, 15...) vor dem Anschließschritt halterbar, beispielsweise durch Festkleben, Festschnappen und dgl. sind.

13. Gitterbauteil nach einem der Ansprüche 11 und 12, dadurch gekennzeichnet, daß die Verbindungsstücke (24, 25...) etwa im mittleren Bereich der Seitenlinien des Vieleckes angeordnet sind.

14. Gitterbauteil nach einem der Ansprüche 11 bis 13, dadurch gekennzeichnet, daß die zum Anschluß der Wechselstromleitungen dienenden Zapfen (30, 31) einen Teilbereich zweier parallel verlaufender Seitenlinien bilden und über eine der quer dazu verlaufenden Seitenlinien hinausragen und daß an den diese Seitenlinie überragenden Bereichen je eine Anschlußstelle (36, 37) angebracht ist.

15. Gitterbauteil nach Anspruch 14, dadurch gekennzeichnet, daß die Anschlußstellen als Anschlußklemmen (36, 37) ausgebildet sind.

16. Gitterbauteil nach einem der Ansprüche 11 bis 15, dadurch gekennzeichnet, daß an die Außenseiten der die Vorsprünge (34, 35) bildenden Schenkel der L-förmigen Verbindungsstücke (24, 25) L-förmig ausgebildete Stege (43, 44) mit je einem Stegschenkel (45, 46) anschließen, deren andere Stegschenkel (47, 48) aufeinanderzugerichtet sind und an ihren freien Enden an einem Verbindungsstück (27) anschließen.

17. Gitterbauteil nach Anspruch 16, dadurch gekennzeichnet, daß an je einem anderen Stegschenkel ein weiterer Steg (53, 54) anschließt.

18. Gitterbauteil nach einem der Ansprüche 11 bis 17, dadurch gekennzeichnet, daß eines der Verbindungsstücke (26) zwischen zwei senkrecht zu den Schenkeln der Verbindungsstücke (24, 25) an diesen anschließenden Stegen (41, 42) angebracht sind.

19. Gitterbauteil nach einem der Ansprüche 11 bis 18, dadurch gekennzeichnet, daß der Stegzug der weiteren Stege (49) bogenförmig verläuft und mit seinen Enden an je einem Verbindungspunkt zwischen den Schenkeln mit den Anschlußstellen und den Stegen (41, 42) anschließt.

Fig.1

Fig.4

Fig.2

Fig.3

Fig. 5

a)

55    53    65    66

b)

67    68

16

c)

Fig. 6

69    26

70    142    14

a)

b)

14

142

c)

71

Fig. 7

76    74

75    30

72

6

73

78    77